Europäisches Patentamt

European Patent Office

Office européen des brevets

(19)

(11) **EP 0 697 125 B1**

(12) **EUROPÄISCHE PATENTSCHRIFT**

(45) Veröffentlichungstag und Bekanntmachung des Hinweises auf die Patenterteilung:
**14.07.1999 Patentblatt 1999/28**

(21) Anmeldenummer: **94912472.1**

(22) Anmeldetag: **20.04.1994**

(51) Int Cl.⁶: **G10L 9/14**, G10L 3/00

(86) Internationale Anmeldenummer:
**PCT/DE94/00435**

(87) Internationale Veröffentlichungsnummer:
**WO 94/27286 (24.11.1994 Gazette 1994/26)**

(54) **VERFAHREN ZUR VEKTORQUANTISIERUNG, INSBESONDERE VON SPRACHSIGNALEN**

PROCESS FOR VECTOR QUANTIZATION, ESPECIALLY OF VOICE SIGNALS

PROCEDE DE QUANTIFICATION VECTORIELLE, NOTAMMENT DE SIGNAUX VOCAUX

(84) Benannte Vertragsstaaten:
**DE DK ES FR GB IT PT**

(30) Priorität: **07.05.1993 DE 4315315**

(43) Veröffentlichungstag der Anmeldung:
**21.02.1996 Patentblatt 1996/08**

(73) Patentinhaber: **ROBERT BOSCH GMBH**
**70442 Stuttgart (DE)**

(72) Erfinder:
• **MÜLLER, Jörg-Martin**
**D-71409 Schwaikheim (DE)**

• **WÄCHTER, Bertram**
**D-71573 Allmersbach/Tal (DE)**

(56) Entgegenhaltungen:
**EP-A- 0 545 386**          **WO-A-91/01545**

• **SPEECH COMMUNICATION, Bd.8, 1989, NL Seiten 363 - 369 MÜLLER 'Improving Performance of Code Excited LPC-Coders by Joint Optimization'**

**Beschreibung**

Die Erfindung bezieht sich auf ein Verfahren zur Codierung von Signalabtastwerten unter Verwendung der Vektorquantisierung.

Aus Speech Communication 8(1989) Seiten 363 bis 369 ist ein CELP-Sprachcodierverfahren bekannt, bei dem die Coderparameter gemeinsam optimiert werden. Im Vergleich zur sequentiellen Optimierung kann die Länge des Anregungscodebuches beträchtlich reduziert werden.

Aus WO 91/01545 ist ein digitaler Sprachcoder bekannt, bei dem auf in einem Codebuch eingetragenen Anregungsvektoren zugegriffen wird, um einen Anregungsvektor zu selektieren, welcher am besten den ursprünglichen Sprachabtastwert repräsentiert. Im Sprachcoder gemäß WO 91/01545 werden zwei Anregungsvektoren in jeweils einem von zwei Codebüchern zur Beschreibung eines Sprachabtastwertes herangezogen. Zuerst wird dort ein erster Anregungsvektor unabhängig von einer Pitchinformation ausgewählt und orthogonalisiert. Der zweite Anregungsvektor wird in entsprechender Weise ausgewählt. Bei der Orthogonalisierung des zweiten Anregungsvektors vom zweiten Codebuch wird sowohl der resultierende Vektor wie auch der ausgewählte erste Anregungsvektor vom ersten Codebuch berücksichtigt. Dieser Auswahlprozeß wird dann mit einem orthogonalisierten Anregungssignal vom zweiten Codebuch wiederholt, um schließlich jene Anregungsvektoren zu identifizieren, die mit dem ursprünglichen Sprachabtastwert am besten übereinstimmen.

Aufgabe vorliegender Erfindung ist es, die Zuverlässigkeit bei der Auswahl des optimierten Abtastwertes zu erhöhen, ohne daß der Verarbeitungsaufwand zu stark erhöht wird. Diese Aufgabe wird durch die Maßnahmen des Patentanspruchs 1 gelöst. Die weiteren Ansprüche zeigen vorteilhafte Weiterbildungen auf.

Die Erfindung beruht auf folgenden Erkenntnissen: Wenn im Gegensatz zu bekannten Verfahren (Speech Communications 8 (1989), Seiten 363 bis 369 oder WO 91/01545) aus dem adaptiven (zweiten) Codebuch mehr als ein Vektor mit minimalem Fehler zur Verknüpfung mit allen Vektoren des ersten (festen) Codebuchs herangezogen wird, steigt zwar der Verarbeitungsaufwnd (Rechenaufwand) an, aber die Zuverlässigkeit bei der Optimierung des Abtastwertes mit dem kleinsten Fehler ist erhöht. Diese Erhöhung der Zuverlässigkeit bedeutet bei der Verarbeitung von Sprachabtastwerten eine bessere Sprachqualität. Da der Verarbeitungsaufwand bei Berücksichtigung von mehr als einem Vektor aus dem adaptiven Codebuch weniger stark als linear ansteigt, kann bei moderater Verkleinerung des festen Codebuchs, z.B. durch eine Codebuchausdünnung (Frameausdünnung) gemäß der Patentanmeldung der Anmelderin "Verfahren zur Aufbereitung von Daten, insbesondere von codierten Sprachsignalparametern" mit gleichem Anmeldetag, der Verarbeitungsaufwand sogar in etwa konstant gehalten werden kann, wobei als Vergleichsbasis die ursprüngliche Codebuchlänge ohne Frameausdünnung zugrunde gelegt ist. Bei etwa gleichem Verarbeitungsaufwand als bei herkömmlichen Verfahen, ist mit den Maßnahmen der Erfindung eine wesentlich höhere Sprachqualität erzielbar.

Anhand der Zeichnungen wird ein Ausführungsbeispiel der Erfindung nun näher Erläutert. Es zeigen

Figur 1 die Struktur eines CELP-Coder und

Figur 2 die Struktur eines modifizierten CELP-Coders

Zur besseren Erläuterung der Erfindung wird zuerst auf die Veröffentlichung "Improving Performance of Code Excidet LPC-Coders by Joint Optimization" in Speech Communication 8 (1989) Seiten 363 bis 369 Bezug genommen.

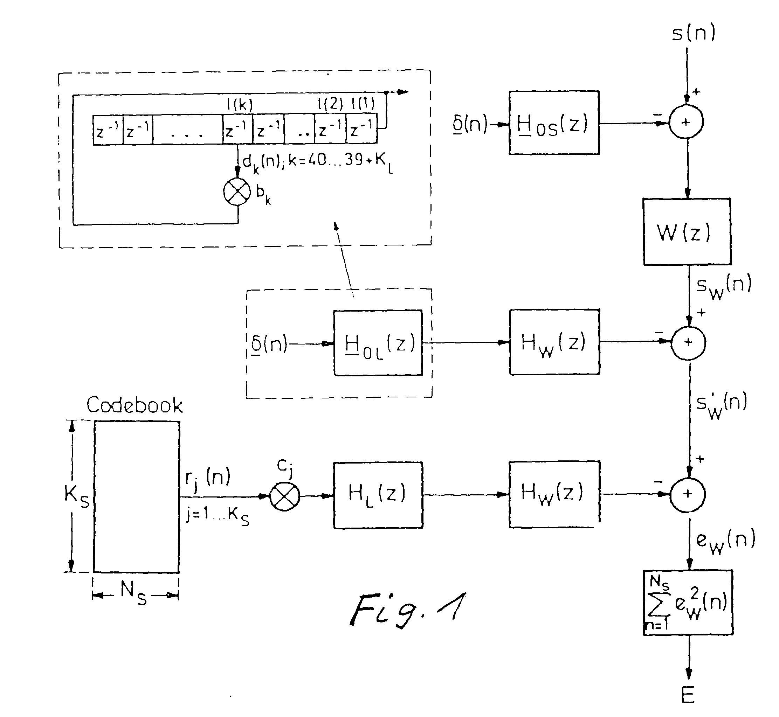

CELP (Code-excited linear prediction)-Coder gehören zur Klasse der RELP (Residual Excited Linear Prediction)-Coder, bei denen eine Aktualisierungssequenz von Sprachwerten mittels eines Filters gewonnen wird, der die Spracherzeugung repräsentiert. Die Aktualisierungssequenz wird mittels eines Codebuchs gewonnen, aus dem der beste Codebuchvektor in einer "Analyse durch Synthese" Methode selektiert wird. Bester Codebuchvektor bedeutet hier jener Vektor, der zum ursprünglichen Sprachabtastwert die größte Ähnlichkeit hat. Diese Ähnlichkeit wird anhand eines vorgegebenen Fehlerkriteriums, z.B. dem mittleren quadratischen Fehler, beurteilt. Das Codebuch wird zuerst mit gaußverteilten Zufallswerten besetzt. Die Struktur eines CELP-Coders ist aus Figur 1 ersichtlich. In einem ersten Schritt wird der Beitrag des Speichers des linearen Prädiktionsfilters, in Figur 1 charakterisiert durch die Übertragungsfunktion $H_{oS}(Z)$ vom eingangsseitigen Sprachabtastwert $s_{(n)}$ subtrahiert und das resultierende Signal durch ein Filter mit der Übertragungsfunktion $W(Z)$ gewichtet. In einem zweiten Schritt wird der Beitrag des gewichteten Speicherwertes des Pitch-Prädiktionsfilters (charakterisiert durch die Übertragungsfunktionen $H_{oL}(Z)$ und $H_W(Z)$) subtrahiert. Schließlich wird das gewichtete Fehlersignal $e_w(n)$ erzeugt durch Differenzbildung zwischen dem gefilterten Codebuchvektor (Filterfunktionen $H_L(Z)$ und $H_W(Z)$) und dem zuvor ermittelten Signal $s_W(n)$. Die Energie des Fehlersignals $e_w(n)$ ist eine Funktion aller Coderparameter, z.B.

$$E = f(a_i, M, b_i, j, c_j),$$

2

worin $a_i$ mit i = 1,2,..., $P_S$ die Koeffizienten des LP-Filters,

M die Pitchperiode,
$b_i$ mit i = 1,2,..., $P_L$ die Pitchprädiktorkoeffizienten,
j = 1,2...$K_s$ die Codebucheinträge und
$c_j$ den korrespondierenden Skalierungsfaktor angibt.

Die bestmögliche Sprachqualität wird erreicht, wenn alle diese Signalparameter gemeinsam optimiert werden. Für die nachfolgende Optimierung werden die LP-Parameter $a_i$ nicht betrachtet, da ihre Berücksichtigung einen kaum realisierbaren Rechenaufwand bedeutet.
Durch Minimierung der Funktion

$$E = f(M, b_i, j, C_i)$$

wird eine suboptimale Näherung erreicht.
Das lineare Prädiktionssynthesefilter

$$H_S(Z) = \left(1 - \sum_{i=1}^{P_s} a_i \, Z^{-i}\right)^{-1}$$

beschreibt die Formantstruktur des Sprachspektrums. Das Gewichtungsfilter

$$W(Z) = H_S(Z/\gamma) \, H_S(Z)^{-1}$$

mit

$$0 \leq \gamma \leq 1$$

liefert eine spektrale Rauschbegrenzung infolge der unvollständigen Anregung. $H_W(Z)$ liefert die Verkettung des LP-Filters und des Gewichtungsfilter:

$$H_W(Z) = H_S(Z) \cdot W(Z)$$

Das Pitch-Prädiktionssynthesefilter, welches nur eine Anzapfung bei $p_L = 1$ hat, ist durch die Übertragungsfunktion

$$H_L(Z) = (1 - bZ^{-M})^{-1}$$

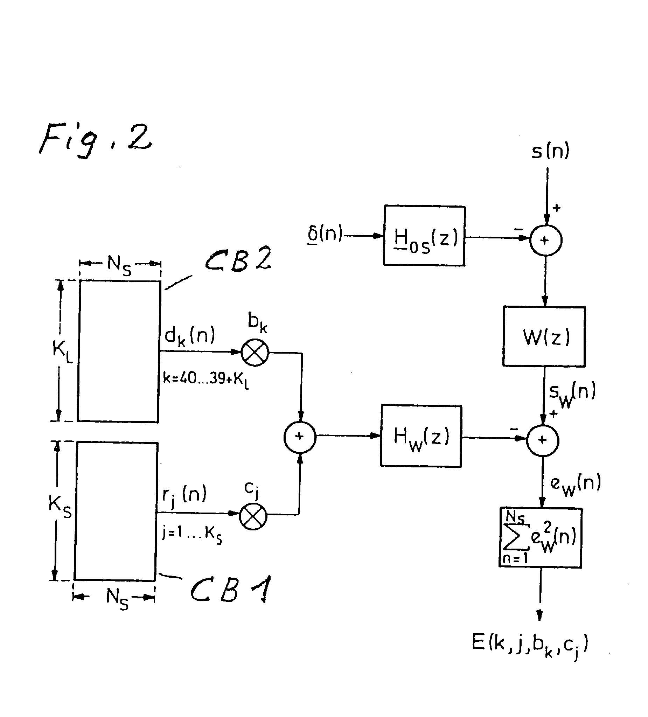

beschrieben.
Die Speicherzellen der Filter $H_W(Z)$, $H_L(Z)$ und $W(Z)$ in Figur 1 sind Null. Die Parameter des Pitch-Prädiktors werden jeweils nach $N_s$ Abtastwerten (Subframeinhalt) und jene des LP-Filters alle N Abtastwerte aktualisiert. Mit der Annahme $N \geq N_s$ kann das Pitch-Prädiktionsfilter aus dem Anregungszweig in Figur 1 entfernt werden, da es den Eingang des Filters $H_W(Z)$ für
$n \leq N_s$ nicht beeinflußt.
Um die Wirkung des Pitch-Prädiktor Speichers näher zu erläutern, sind in Figur 1 seine Speicherzellen und ihre Verknüpfung detailliert dargestellt. Die Werte in den Speicherzellen sind mit 1(k) bezeichnet. Jeder Pitchperiodenparameter M = k generiert ein anderes Signal $d_k(n)$ am Ausgang der aus den Speicherzellen gebildeten Verzögerungsleitung. $K_L$ hängt vom zugelassenen Bereich der Pitchperiode M ab. Eine gute Wahl für M liegt zwischen 40 und 103. Um diesen Bereich abzudecken muß $K_L = 64$ sein.
Diese Voraussetzungen führen direkt zum Blockschaltbild gemäß Figur 2.

Die $K_L$ verschiedenen Signale $d_k(n)$ können als in einem Codebuch zusammengefaßt betrachtet werden. In dieser Darstellung gibt es keinen Unterschied in der Struktur des Zweiges mit dem Anregungscodebuch CB1 und dem Zweig mit dem Codebuch CB2, welches aus dem Filterspeicher des Pitch-Prädiktors hervorgeht. Nur die Charakteristiken der beiden Codebücher CB1 und CB2 unterscheiden sich: Das Anregungscodebuch CB1 ist fest - es werden feste Vektoren eingetragen - wohingegen das Codebuch CB2 für die Pitchparameter zeitabhängig (adaptiv) ist, da der Filterspeicher nach jedem Subframe modifiziert wird. Zur Optimierung dieser Parameter muß eine große Zahl ($K_L K_S$) verschiedener Kombination durchsucht werden, um die minimale Fehlerenergie E zu finden. Alle diese Kombinationen korrespondieren zu einer Codebuchlänge $K_L K_S$, wohingegen die sequentielle Optimierung zu einer zweistufigen Vektorquantisierung korrespondiert mit zwei Codebüchern der Länge $K_L$ bzw. $K_S$.

Mit dem Blockschaltbild gemäß Figur 2 ist die Fehlerenergie E eine Funktion der Codebucheinträge j und k und der Skalierungsfaktoren $c_j$ und $b_K$:

$$E(j,k,b_k,,c_j) = \sum_{n=1}^{N_S} [s_w(n) - [(b_k \ d_k(n) + c_j \ r_j(n)) * h_w(n)]]^2$$

wobei $h_W(n)$ die Impulsantwort des gewichteten LP-Filters und * das Faltungssymbol angibt.

Für ein Minimum der Fehlerenergie E hinsichtlich der Skalierungsfaktoren muß das folgende System linearer Gleichungen erfüllt werden:

$$\begin{pmatrix} <p_k(n), \ p_k(n)> & <p_k(n), \ q_j(n)> \\ <p_k(n), \ q_j(n)> & <q_j(n), \ q_j(n)> \end{pmatrix} \begin{pmatrix} b_k \\ c_j \end{pmatrix} \approx \begin{pmatrix} <p_k(n), \ s_W(n)> \\ <q_j(n), \ s_W(n)> \end{pmatrix}.$$

mit

$$p_k(n) = d_k(n) * h_W(n),$$
$$q_j(n) = r_j(n) * h_W(n),$$

und

$$<a_{(n)}, \ b_{(n)}> = \sum_{n=1}^{N_S} a(n) \ b(n).$$

Unter Verwendung dieser Beziehungen ergibt sich für die minimale Fehlerenergie

$$E_{min} = <s_W(n), s_W(n)> - T(j,k,c_j,b_k).$$

Da die Energie für einen Subframe konstant ist, muß der Ausdruck

$$T(j,k,c_j,b_k) = b_k <p_k(n), s_W(n)> + c_j <q_j(n), s_W(n)>$$

maximiert werden. Diese Maximierung wird in zwei Schritten durchgeführt:

- Lösung des linearen Gleichungssystems,
- Berechnung von $T(j,k,c_j,b_n)$.

Diese Schritte müssen $K_L K_S$ mal durchgeführt werden. Mit weiteren Vereinfachungen, z.B. Nullsetzen von etwa 90 % der Vektoren, Inversfilterung gemäß DE 38 34 871 C1, Zulassen nur von Vektoren, die z.B. nur drei vom Wert Null verschiedene Autokorrelationskoeffizienten aufweisen, kann der Aufwand beträchtlich reduziert werden.

Erfindungsgemäß und im Gegensatz zu bisherigen Verfahren werden nun aus dem zweiten Codebuch CB2 n≥2, im Beispiel n = 2 beste Vektoren ausgewählt (beste Vektoren bedeutet, daß diese Vektoren hinsichtlich eines Fehlerkriteriums, z.B. dem mittleren quadratischen Fehler, die geringsten Abweichungen, d.h. die besten Prädiktionswerte, liefern. Diese zwei besten Vektoren werden nun mit allen vorhandenen Vektoren aus dem ersten Codebuch CB1, das die Festvektoren enthält, gemäß vogenanntem System linearer Gleichungen verknüpft. Aus der Verknüpfungsmenge werden die im Sinne minimaler Fehlerenergie (gleiches oder weiteres Fehlerkriterium) zum ursprünglichen Abtastwert gelegenen Werte ausgewählt und z.B. zur Übertragung über einen Übertragungskanal niedriger Bitrate bereitgestellt.

Der durch die Verarbeitung von mehr als zwei besten Vektoren aus dem zweiten Codebuch erhöhte Verarbeitungsaufwand führt zu einer besseren Sprachqualität. Ohne diese erhöhte Sprachqualität zu vermindern, läßt sich der Verarbeitungsaufwand dadurch wieder reduzieren, daß die Eintragungen im ersten Codebuch CB1 ausgedünnt werden. Außerdem steigt der Verarbeitungsaufwand mit der Zahl zu verarbeitender ausgewählter Vektoren nicht linear an, da auf viele bereits im ersten Schritt berechnete Verknüpfungsergebnisse zurückgegriffen werden kann.

Die Codebuchausdünnung wird vorteilhaft ohne Verminderung der Sprachqualität so vorgenommen, daß als Ausdünnungsmenge die Summenbits der Vektoren zweier Rahmenabschnitte (Subframes) zugrunde gelegt wird, aus der dann vorzugsweise gerade soviele Bits unterdrückt werden, daß der Verarbeitungsaufwand etwa genauso groß ist wie bei einer Verarbeitung nur eines ausgewählten besten Vektors aus dem zweiten Codebuch CB2. Die Codebuchausdünnung im Detail ist in der eingangs erwähnten Anmeldung der Anmelderin mit dem gleichen Anmeldetag beschrieben.

**Patentansprüche**

1. Verfahren zur Vektorquantisierung von Signalabtastwerten, insbesondere von Sprachabtastwerten, mit folgenden Schritten:

   - in einem ersten Codebuch (CB1) werden feste Vektoren eingetragen,
   - in einem zweiten Codebuch (CB2) werden Vektoren eingetragen, die nach jeweils einem Zeitabschnitt aktualisiert werden,
   - aus dem zweiten Codebuch (CB2) werden mindestens zwei Vektoren ausgewählt, die anhand eines vorgegebenen ersten Fehlerkriteriums die besten Prädiktionswerte ergeben,
   - die mindestens zwei aus dem zweiten Codebuch (CB2) ausgewählten Vektoren werden jeweils mit den Vektoren aus dem ersten Codebuch (CB1) verknüpft,
   - aus der Verknüpfungsmenge der Vektoren wird jener Vektor als Repräsentant für einen optimierten Abtastwert ausgewählt, der anhand des ersten oder eines weiteren Fehlerkriteriums den geringsten Abstand zum ursprünglichen Abtastwert aufweist.

2. Verfahren nach Anspruch 1, dadurch gekennzeichnet, daß im ersten Codebuch (CB1) Anregungsvektoren für ein LPC-Filter zur Sprachprädiktion eingetragen werden.

3. Verfahren nach Anspruch 1 oder 2, dadurch gekennzeichnet, daß im zweiten Codebuch (CB2) Anregungsvektoren für ein Pitchsynthesefilter eingetragen werden.

4. Verfahren nach einem der Ansprüche 1 bis 3, dadurch gekennzeichnet, daß die Eintragungen im ersten Codebuch (CB1) ausgedünnt werden.

5. Verfahren nach einem der Ansprüche 1 bis 4, dadurch gekennzeichnet, daß für jeden Anregungsvektor aus dem ersten Codebuch (CB1) jenes Fehlermaß zum ursprünglichen Abtastwert bestimmt wird, das jeweils die mindestens zwei aus dem zweiten Codebuch (CB2) ausgewählten Prädiktionswerte/Pitchprädiktoren berücksichtigt.

6. Verfahren nach Anspruch 4 oder 5, dadurch gekennzeichnet, daß zur Ausdünnung des ersten Codebuchs (CB1) Vektorkomponenten unterdrückt werden, die vorzugsweise aus den Summenbits zweier Rahmenabschnitte, in die das Sprachsignal eingeteilt ist, entnommen werden.

7. Verfahren nach einem der Ansprüche 4 bis 6, dadurch gekennzeichnet, daß die Ausdünnung der Eintragungen im ersten Codebuch (CB1) in dem Maße vorgenommen wird, daß der Verarbeitungsaufwand etwa genauso groß ist, wie bei einer Verarbeitung mit nur einem ausgewählten Vektor aus dem zweiten Codebuch (CB2).

**Claims**

1. Method for the vector quantization of signal samples, especially of voice samples, comprising the following steps:

   - fixed vectors are entered in a first code book (CB1),
   - vectors which are updated after in each case one time interval are entered in a second code book (CB2),
   - from the second code book (CB2), at least two vectors are selected which produce the best prediction values by means of a predetermined first error criterion,
   - the at least two vectors selected from the second code book (CB2) are in each case logically combined with the vectors from the first code book (CB1),
   - from the logically combined set of vectors, the vector which has the smallest distance from the original sample, on the basis of the first or a further error criterion, is selected as representative for an optimized sample.

2. Method according to Claim 1, characterized in that excitation vectors for an LPC filter for voice prediction are entered in the first code book (CB1).

3. Method according to Claim 1 or 2, characterized in that excitation vectors for a pitch synthesis filter are entered in the second code book (CB2).

4. Method according to one of Claims 1 to 3, characterized in that the entries in the first code book (CB1) are thinned out.

5. Method according to one of Claims 1 to 4, characterized in that for each excitation vector from the first code book (CB1), the error dimension, with respect to the original sample, which in each case takes into consideration the at least two prediction values/pitch predictors selected from the second code book (CB2), is determined.

6. Method according to Claim 4 or 5, characterized in that, for the purpose of thinning out the first code book (CB1), vector components, which are preferably taken from the sum bits of two subframes into which the voice signal is divided, are suppressed.

7. Method according to one of Claims 4 to 6, characterized in that the thinning out of the entries in the first code book (CB1) is carried out to such an extent that the amount of processing is approximately the same as in the case of processing involving only one selected vector from the second code book (CB2).

**Revendications**

1. Procédé de quantification vectorielle de valeurs de détection de signaux, notamment de valeurs de détection de voix, comprenant les étapes suivantes :

   - on enregistre des vecteurs fixes dans un premier livre de code (CB1),
   - on enregistre des vecteurs actualisés après chaque fois un segment de temps, dans un second livre de code (CB2),
   - dans le second livre de code (CB2) on sélectionne au moins deux vecteurs qui donnent les meilleures valeurs prévisionnelles, à l'aide d'un premier critère d'erreur prédéterminé,
   - au moins deux vecteurs, sélectionnés dans le second livre de code (CB2), sont combinés chaque fois avec les vecteurs du premier livre de code (CB1),
   - on sélectionne comme vecteur représentant une valeur de détection optimisée, à partir de la quantité combinée des vecteurs, le vecteur qui présente la plus faible distance par rapport à la valeur de détection d'origine, à l'aide d'un premier ou d'un autre critère d'erreur.

2. Procédé selon la revendication 1,
   caractérisé en ce que
   dans le premier livre de code (CB1) on enregistre les vecteurs d'excitation d'un filtre LPC pour la prévision vocale.

3. Procédé selon la revendication 1 ou 2,
caractérisé en ce qu'
on enregistre les vecteurs d'excitation pour un filtre de synthèse de pas, dans le second livre de code (CB2).

4. Procédé selon l'une des revendications 1 à 3,
caractérisé en ce que
l'enregistrement est dilué dans le premier livre de code (CB1).

5. Procédé selon l'une des revendications 1 à 4,
caractérisé en ce que
pour chaque vecteur d'excitation, à partir du premier livre de code (CB1), on détermine la mesure d'erreur respective par rapport à la valeur de détection d'origine, pour tenir compte chaque fois au moins des deux valeurs prévisionnelles/prédicteur de pas, sélectionnées dans le second livre de code (CB2).

6. Procédé selon l'une des revendications 4 ou 5,
caractérisé en ce que
pour diluer le premier livre de code (CB1) on élimine des composantes vectorielles prises de préférence à partir des bits de deux segments de trame dans lesquels est subdivisé le signal vocal.

7. Procédé selon l'une des revendications 4 à 6,
caractérisé en ce que
la dilution des enregistrements dans le premier livre de code (CB1) se fait dans la mesure où le moyen de traitement à mettre en oeuvre est sensiblement de même taille que pour un traitement avec seulement un vecteur sélectionné dans le second livre codé (CB2).

Fig. 1

Fig. 2

EP 0 697 125 B1